(19) Europäisches Patentamt
European Patent Office
Office européen des brevets

(11) EP 2 346 106 A1

(12) **EUROPEAN PATENT APPLICATION**
published in accordance with Art. 153(4) EPC

(43) Date of publication:
**20.07.2011 Bulletin 2011/29**

(21) Application number: **09823311.7**

(22) Date of filing: **28.10.2009**

(51) Int Cl.:
***H01L 51/42*** *(2006.01)*

(86) International application number:
**PCT/JP2009/005696**

(87) International publication number:
**WO 2010/050198 (06.05.2010 Gazette 2010/18)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **30.10.2008 JP 2008279881**

(71) Applicant: **Idemitsu Kosan Co., Ltd.**
**Chiyoda-ku**
**Tokyo 100-8321 (JP)**

(72) Inventors:
- **MAEDA, Ryoji**
**Sodegaura-shi**
**Chiba 299-0293 (JP)**
- **NAGASHIMA, Hideaki**
**Sodegaura-shi**
**Chiba 299-0293 (JP)**
- **MATSUURA, Masahide**
**Sodegaura-shi**
**Chiba 299-0293 (JP)**

(74) Representative: **Gille Hrabal Struck Neidlein Prop Roos**
**Patentanwälte**
**Brucknerstrasse 20**
**40593 Düsseldorf (DE)**

# (54) ORGANIC SOLAR BATTERY

(57) An organic solar battery (1) includes a photoelectric conversion layer that includes an electron donor layer (12) and an electron acceptor layer (14, 16, 17, 18) stacked on the electron donor layer, the electron acceptor layer including three or more electron acceptor materials, and at least one of the three or more electron acceptor materials being an organic material.

FIG.1

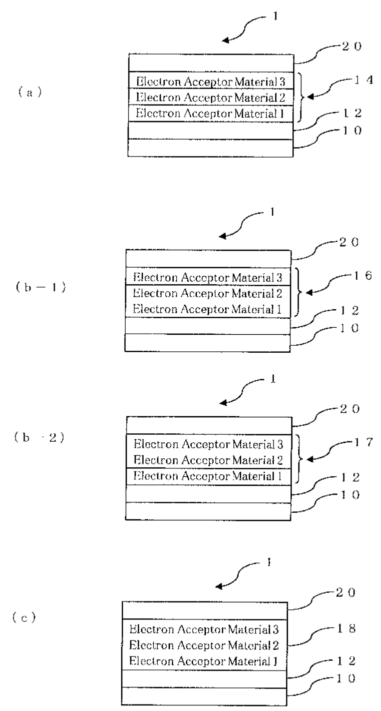


EP 2 346 106 A1

**Description**

TECHNICAL FIELD

The invention relates to an organic solar battery that includes a photoelectric conversion layer that receives light and generates electricity.

BACKGROUND ART

A photoelectric conversion device receives light, and outputs electricity. For example, a photodiode or an imaging device converts an optical signal into an electrical signal, and a solar battery converts the energy of light into electrical energy. The photoelectric conversion element shows a response opposite to that of an electroluminescence (EL) device that receives electricity and outputs light. In recent years, a solar battery has attracted remarkable attention as a clean energy source taking into account of depletion of fossil fuels and global warming, and extensively researched and developed. Silicon solar batteries (e.g., single crystal silicon, polycrystalline silicon, and amorphous silicon) have been put to practical use. However, since silicon solar batteries are expensive, and a shortage of silicon and other problems have been revealed, a next-generation solar battery is being increasingly desired. In view of the above situation, an organic solar battery that is inexpensive, has low toxicity, and does not suffer a shortage of the raw materials has attracted significant attention as a next-generation solar battery that can replace a silicon solar battery.

The organic solar battery does not undergo leakage or the like due to an all-solid configuration, can be easily produced, and does not utilize a scarce metal (e.g., ruthenium). Therefore, the organic solar battery has attracted attention and has been extensively studied.

An organic solar battery having a single-layer film utilizing a merocyanine dye or the like was initially studied. It was then found that the conversion efficiency is improved by utilizing a p/n multilayer film, and an organic solar battery having a multilayer film has been mainly studied. It was also found that the conversion efficiency is improved by increasing the number of layers by inserting an i layer (i.e., a mixed layer of a p material and an n material) between the p layer and the n layer. It was also found that the conversion efficiency is further improved by employing a tandem cell configuration in which p/i/n layers are stacked in series.

The so-called bulk heterostructure has been mainly studied for an organic solar battery that utilizes a polymer. Specifically, the conversion efficiency is improved by mixing a conductive polymer as a p material with a $C_{60}$ fullerene derivative as an n material, and heating the mixture to induce microlayer separation and increase the number of hetero-interfaces.

As described above, the conversion efficiency of the organic solar battery has been improved by optimizing the cell configuration and the morphology.

However, it is difficult to put the organic solar battery to practical use since the organic solar battery has poor photoelectric conversion efficiency as compared with an inorganic solar battery (e.g., silicon solar battery). Therefore, the biggest challenge for the organic solar battery is to improve the photoelectric conversion efficiency. The operation process of the organic solar battery normally includes elementary steps (1) optical absorption and exciton generation, (2) exciton diffusion, (3) charge separation, (4) carrier transfer, and (5) electromotive force generation. It is necessary to improve the efficiency of each elementary step in order to improve the photoelectric conversion efficiency of the organic solar battery.

Since an organic material normally does not have absorption characteristics that match the sunlight spectrum, and generally exhibits low carrier mobility, it is generally difficult to achieve high conversion efficiency.

Non-patent Document 1 states that the conversion efficiency is improved as compared with an organic solar battery using a single-layer film by effecting optical absorption using two organic materials (phthalocyanine and perylene imide), and achieving carrier (hole/electron) transport using an electron donor layer and an electron acceptor layer, for example. However, an improvement in conversion efficiency is not necessarily sufficient.

Non-patent Document 2 states that the conversion efficiency is improved by stacking bathocuproine (BCP) (electron acceptor layer) that is a phenanthroline derivative having an electron transport capability and an exciton blocking capability on PTCBI (electron acceptor material). Non-patent Document 3 states that the conversion efficiency is improved by stacking $C_{60}$ fullerene (electron acceptor material) having a high electron transport capability on BCP to form a stacked film. However, Non-patent Document 3 utilizes a normal cell configuration.

RELATED-ART DOCUMENT

NON-PATENT DOCUMENT

Non-patent Document 1: C. W. Tang, Appl. Phys. Lett. 48, 183 (1986)
Non-patent Document 2: P. Peumans, V. Bulovic, and S. R. Forrest, Appl. Phys. Lett. 76, 2650 (2000)
Non-patent Document 3: P. Peumans and S. R. Forrest, Appl. Phys. Lett. 79, 126 (2001)

SUMMARY OF THE INVENTION

As described above, an organic solar battery that exhibits sufficiently high photoelectric conversion efficiency has not been obtained.
An object of the invention is to provide an organic solar battery that exhibits high photoelectric conversion efficiency.
The inventors of the invention conducted extensive studies from the viewpoint of the device design in order to obtain an organic solar battery that exhibits sufficiently high photoelectric conversion efficiency. As a result, the inventors found that a cell configuration of an electron acceptor thin film using three or more electron acceptor materials (including BCP) has not been proposed, and the conversion efficiency is improved by employing a cell configuration formed by stacking or mixing three or more electron acceptor materials. This finding has led to the completion of the invention.
The invention provides the following organic solar battery.

1. An organic solar battery comprising a photoelectric conversion layer that includes an electron donor layer and an electron acceptor layer stacked on the electron donor layer, the electron acceptor layer including three or more electron acceptor materials, and at least one of the three or more electron acceptor materials being an organic material.
2. The organic solar battery according to 1, wherein the electron acceptor layer comprises a plurality of layers that respectively include one of the three or more electron acceptor materials.
3. The organic solar battery according to 1, wherein the electron acceptor layer comprises a plurality of layers including a layer that includes at least two of the three or more electron acceptor materials in a mixed state.
4. The organic solar battery according to 1, wherein the electron acceptor layer comprises a single layer that includes the three or more electron acceptor materials in a mixed state.
5. The organic solar battery according to any one of 1 to 4, wherein the three or more electron acceptor materials differ in thin-film absorption spectrum peak wavelength.
6. The organic solar battery according to any one of 1 to 5, wherein at least one of the three or more electron acceptor materials is selected from the group consisting of fullerenes.
7. The organic solar battery according to any one of 1 to 6, wherein one of the three or more electron acceptor materials is $C_{60}$ fullerene, and another of the three or more electron acceptor materials is selected from the group consisting of fullerenes having 61 or more carbon atoms.

According to the invention, an organic solar battery that exhibits high photoelectric conversion efficiency can be provided.

BRIEF DESCRIPTION OF THE DRAWINGS

FIG. 1 is a schematic view showing configurations (a), (b-1), (b-2), and (c) of an organic solar battery according to one embodiment of the invention.

MODE FOR CARRYING OUT THE INVENTION

An organic solar battery (hereinafter may be referred to as "solar battery") according to the invention includes a photoelectric conversion layer that includes an electron donor layer and an electron acceptor layer stacked on the electron donor layer, the electron acceptor layer including three or more electron acceptor materials, and at least one of the three or more electron acceptor materials being an organic material.
The solar battery according to the invention includes an electron-donor or electron-acceptor organic semiconductor thin film, and is characterized in that excitons produced by dye/organic molecules due to absorption of light move to an internal electric field generated at the contact interface with an electrode or another thin film so that charge separation occurs to obtain an electromotive force.

As long as the electron acceptor layer in the solar battery according to the invention includes three or more electron acceptor materials, it may include (a) a plurality of layers that respectively include one of the three or more electron acceptor materials, (b) a plurality of layers including a layer that includes at least two of the three or more electron acceptor materials in a mixed state, or (c) a single layer that includes the three or more electron acceptor materials in a mixed state. FIG. 1 shows examples of the layer configuration of the solar battery according to the invention that includes the electron acceptor layer having the configuration (a), (b-1), (b-2), or (c) when using three electron acceptor materials.

A solar battery 1 according to the invention includes a lower electrode 10, an electron donor layer 12, an electron acceptor layer 14, 16, 17, or 18, and an opposite electrode 20, the electron donor layer 12, the electron acceptor layer 14, 16, 17, or 18, and the opposite electrode 20 being stacked on the lower electrode 10.
The electron acceptor layer 14 having the configuration (a) includes a plurality of thin films (hereinafter may be referred to as "electron acceptor thin film") that respectively include one of electron acceptor materials 1 to 3.
The electron acceptor layer 16 having the configuration (b-1) includes a thin film that includes the electron acceptor materials 1 and 2 in a mixed state, and a thin film that includes the electron acceptor material 3.
The electron acceptor layer 17 having the configuration (b-2) includes a thin film that includes the electron acceptor material 1, and a thin film that includes the electron acceptor materials 2 and 3 in a mixed state.
The electron acceptor layer 18 having the configuration (c) includes a thin film that includes the electron acceptor materials 1 to 3 in a mixed state.

The three or more materials included in the electron acceptor layer of the solar battery according to the invention are materials that function as an electron acceptor (hereinafter referred to as "electron acceptor materials"), and at least one of the three or more electron acceptor materials is an organic material. The type of each electron acceptor material is not particularly limited. Each electron acceptor material may be an organic compound or an inorganic compound.
It is preferable that each electron acceptor material have high electron mobility. It is preferable that each electron acceptor material have low electron affinity. A sufficient open-circuit voltage can be obtained by combining a material having low electron affinity (i.e., n layer (electron acceptor layer)) with a p layer (electron donor layer).

An organic compound used for photoelectric conversion may be used as the electron acceptor material. Examples of such an organic compound include fullerenes having 61 or more carbon atoms (e.g., $C_{60}$, $C_{70}$, and $C_{84}$), and fullerene derivatives having 61 or more carbon atoms and obtained by chemically modifying the soluble side chain of a fullerene (e.g., $C_{61}$PCBM and $C_{71}$PCBM). Carbon nanotubes may also be used. Examples of the carbon nanotubes include single-wall nanotubes (SWNT), multi-wall nanotubes (MWNT) such as double-wall nanotubes (DWNT), and the like. Further examples of the organic compound that may be used as the electron acceptor material include perylene derivatives, polycyclic quinones, quinacridon, CN-poly(phenylene-vinylene), MEH-CN-PPV, CN group or $CF_3$ group-containing polymers, $CF_3$-substittued polymers thereof, poly(fluorene) derivatives, and the like.

A compound that has sufficiently high carrier mobility, and has a sufficiently high ionization potential that achieves an exciton blocking effect may also be used as the electron acceptor material. Specific examples of such a compound include bathocuproine (BCP), bathophenanthroline (BPhen), and the like which are known materials in organic EL applications. When the electron acceptor layer includes a plurality of thin films including an electron acceptor material (configuration (a) or (b)), these compounds are preferable as the electron acceptor material included in the electron acceptor thin film that is disposed on the cathode side.

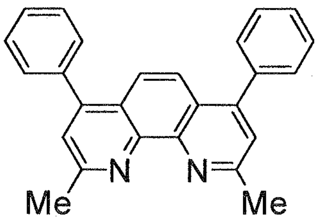

BCP

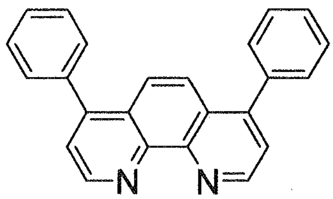

BPhen

wherein Me represents a methyl group.

Examples of the inorganic compound that may be used as the electron acceptor material include n-type inorganic semiconductor compounds. Specific examples of the n-type inorganic semiconductor compounds include doped semiconductors and compound semiconductors such as n-Si, GaAs, CdS, PbS, CdSe, InP, $Nb_2O$ $WO_3$, and $Fe_2O_3$, and conductive oxides such as titanium oxide (e.g., titanium dioxide ($TiO_2$), titanium monoxide (TiO), and dititanium trioxide ($Ti_2O_3$)), zinc oxide (ZnO), tin oxide ($SnO_2$), and indium oxide (ITO, IZO, and AZO). Among these, titanium oxide

is preferable, and titanium dioxide is particularly preferable.

It is preferable that the three or more electron acceptor materials differ in thin-film absorption spectrum peak wavelength. If the three or more electron acceptor materials differ in peak wavelength, it is possible to deal with the sunlight spectrum that ranges from the visible region to the infrared region by absorption of each material, so that the sunlight utilization efficiency and the conversion efficiency are improved.

Moreover, a decrease in internal resistance can be expected due to the difference in electron transporting capability between a plurality of electron acceptor thin films including the three or more electron acceptor materials, so that generated carriers can be efficiently transported to the electrode. This improves the charge extraction efficiency and the conversion efficiency.

When using the electron acceptor layer obtained by stacking (mixing) a plurality of electron acceptor thin films (configuration (a), (b), or (c)), the incident light utilization efficiency can be improved due to energy transfer between the materials that differ in band gap, and the internal resistance can be reduced by disposing the electron acceptor material having a high electron transport capability on the side of the cathode, so that generated carriers can be efficiently transported to the cathode. Energy transfer in the stacked film obtained by stacking the electron acceptor thin films occurs when the emission spectrum of one thin film overlaps the absorption spectrum of the thin film that is adjacent thereto at the pn interface. Examples of the corresponding configuration include lower electrode/p layer/n1 layer/n2 layer/n3 layer/upper electrode (configuration (a)), lower electrode/p layer/n1:n2 layer (mixed layer of n1 material and n2 material)/n3 layer/upper electrode (configuration (b-1)), lower electrode/p layer/n1 layer/n2:n3 layer (mixed layer of n2 material and n3 material)/upper electrode (configuration (b-2)), lower electrode/p layer/n1:n2:n3 layer (mixed layer of n1 material, n2 material, and n3 material)/upper electrode (configuration (c)), and the like.

In order to realize a stacked film configuration that can achieve a charge blocking effect, it is effective that the stacked film of the electron acceptor thin films satisfy the energy level relationship that achieves a hole blocking effect that ensures that electrons produced at the interface are effectively transported to the cathode, but prevents movement of holes to the cathode (i.e., carrier loss).

It is preferable that the materials n1 to n3 that form the electron acceptor layer have an electron transport capability, and at least one of the materials n1 to n3 have an electron mobility higher than that of the remainder. It is preferable that the materials n1 to n3 satisfy the energy level relationship that blocks movement of holes to the cathode. Specifically, it is preferable that the HOMO level (valence electron level) and the LUMO level (conduction level) are almost equal to the vacuum level, or be deeper than the vacuum level toward the cathode.

The solar battery according to the invention includes at least the lower electrode, the electron donor layer, the electron acceptor layer, and the upper electrode (opposite electrode). The details of the electron acceptor layer have been described above. The details of the lower electrode, the upper electrode, and the electron donor layer are described below.

The materials used for the lower electrode and the upper electrode are not particularly limited. A known conductive material may be used. For example, the electrode that comes in contact with the electron donor layer (p layer) may be formed of indium tin oxide (ITO) or a metal such as gold (Au), osmium (Os), or palladium (Pd). The electrode that comes in contact with the electron acceptor layer (n layer) may be formed of a metal such as silver (Ag), aluminum (Al), indium (In), calcium (Ca), platinum (Pt), or lithium (Li), a two-component alloy such as Mg:Ag, Mg:In, or Al:Li, or any of the metals that may be used for the electrode that comes in contact with the electron donor layer (p layer).

In order to obtain highly efficient photoelectric conversion characteristics, it is desirable that at least one side of the solar battery be sufficiently transparent in the sunlight spectrum range. A transparent electrode is formed by deposition, sputtering, or the like using a known conductive material so that a given translucency is achieved. It is desirable that the light-receiving-side electrode have a light transmittance of 10% or more. It is preferable that the pair of electrodes include an electrode that includes a metal having a large work function, and an electrode that includes a metal having a small work function.

The electron donor layer exhibits an electron donor capability. The material used for the electron donor layer (hereinafter referred to as "electron donor material") is preferably a compound that functions as a hole acceptor and has high hole mobility.

Examples of an organic compound used as the electron donor material include organic compounds including an amino group or a fused polycyclic aromatic ring, such as N,N'-bis(3-tolyl)-N,N'-diphenylbenzidine (mTPD), N,N'-dinaphthyl-N, N'-diphenylbenzidine (NPD), and 4,4',4"-tris(phenyt-3-tolylamino)triphenylamine (MTDATA). These organic compounds are preferable from the viewpoint of hole transportation in the carrier transportation process during the operation. Further examples of an organic compound used as the electron donor material include phthalocyanines such as phthalocyanine (Pc), copper phthalocyanine (CuPc), zinc phthalocyanine (ZnPc), and titanylphthalocyanine (TiOPc), and porphyrins such as octaethylporphyrin (OEP), platinum octaethylporphyrin (PtOEP), and zinc tetraphenylporphyrin (ZnTPP).

Examples of a polymer compound used as the electron donor material include main-chain conjugated polymers such as polyhexylthiophene (P3HT), methoxyethylhexyloxyphenylenevinylene (MEHPPV), and cyclopentadithiophene-benzothiadiazole (PCPDTBT), side-chain polymers such as polyvinylcarbazole, and the like.

The photoelectric conversion layer of the solar battery according to the invention may include an i layer that is disposed between the electron donor layer (p layer) and the electron acceptor layer (n layer), and has intermediate properties between the p layer and the n layer. The i layer may include a material having intermediate properties between the electron donor material (p material) and the electron acceptor material (n material), or may include the electron donor material and the electron acceptor material in a mixed state.

An appropriate resin or additive may be added to the electron donor layer, the electron acceptor layer, and the i layer included in the solar battery according to the invention in order to improve the deposition capability and prevent pinholes, for example. Examples of the resin include insulating resins such as polystyrene, polycarbonate, polyallylate, polyester, polyamide, polyurethane, polysulfone, polymethyl methacrylate, polymethyl acrylate, and cellulose, copolymers thereof, photoconductive resins such as poly-N-vinylcarbazole and polysilane, and conductive resins such as polythiophene and polypyrrole.

Examples of the additive include an antioxidant, a UV absorber, a plasticizer, and the like.

The thickness of the electron donor layer and the electron acceptor layer included in the solar battery according to the invention may be appropriately selected. It is known that an organic thin film normally has a short exciton diffusion length. If the thickness of the thin film is too large, excitons may be inactivated before reaching the hetero interface, so that the photoelectric conversion efficiency may deteriorate. If the thickness of the thin film is too small, pinholes and the like may occur, and sufficient diode characteristics may not be obtained. As a result, the conversion efficiency may deteriorate.

The thickness of the electron donor layer is normally 1 nm to 10 μm, preferably 5 nm to 0.2 μm, and more preferably 5 nm to 0.1 μm.

The total thickness of the thin films that form the electron acceptor layer is normally 1 nm to 10 μm, preferably 2 nm to 0.2 μm, and more preferably 5 nm to 0.1 μm.

When using the electron acceptor layer that includes three or more thin films respectively including one electron acceptor material (configuration (a)), the total thickness of the thin films is normally 1 nm to 10 μm, preferably 1 nm to 0.2 μm, and more preferably 2 nm to 0.1 μm.

When using the electron acceptor layer including a thin film that includes at least two electron acceptor materials in a mixed state (configuration (b)), the thickness of each thin film is appropriately set in the same manner as the electron acceptor layer having the configuration (a).

When using the electron acceptor layer including a thin film that includes the three or more electron acceptor materials in a mixed state (configuration (c)), the thickness of the thin film is appropriately set in the same manner as the electron acceptor layer having the configuration (a).

A method of forming thin film that forms the electron donor layer and thin film that forms the electron acceptor layer included in the solar battery according to the invention is described below.

The thin film may be formed by a known thin film-forming method. Specifically, the thin film may be formed by a dry deposition method such as vacuum vapor deposition, sputtering, plasma coating, or ion plating, or a wet deposition method such as spin coating, dip coating, casting, roll coating, flow coating, or an inkjet method.

When using a dry deposition method, a known resistive heating method is preferably employed. The mixed layer that includes the electron acceptor materials in a mixed state (configuration (b) or (c)) is preferably formed by co-deposition from a plurality of vaporization sources. It is preferable to control the substrate temperature during deposition.

When using a wet deposition method, the material for each thin film is dissolved or dispersed in an appropriate solvent to prepare an organic solution, and a thin film is formed by applying the organic solution by spin coating or the like. The solvent is not particularly limited. Examples of the solvent include halogen-containing hydrocarbon solvents such as dichloromethane, dichloroethane, chloroform, carbon tetrachloride, tetrachloroethane, trichloroethane, chlorobenzene, dichlorobenzene, and chlorotoluene; ether solvents such as dibutyl ether, tetrahydrofuran, dioxane, and anisole; alcohol solvents such as methanol, ethanol, propanol, butanol, pentanol, hexanol, cyclohexanol, methyl cellosolve, ethyl cellosolve, and ethylene glycol; hydrocarbon solvents such as benzene, toluene, xylene, ethylbenzene, hexane, octane, decane, and tetralin; ester solvents such as ethyl acetate, butyl acetate, and amyl acetate; and the like. Among these, the hydrocarbon solvents and the ether solvents are preferable. These solvents may be used singly or in combination. Usable solvents are not limited to those mentioned above.

## EXAMPLES

The invention is further described below by way of examples. Note that the invention is not limited to the following examples.

(Example 1)

A glass substrate with an ITO transparent electrode (25×75×0.7 mm) was subjected to ultrasonic cleaning for

5 minutes in isopropyl alcohol, and then subjected to UV ozone cleaning for 30 minutes. The cleaned glass substrate with a transparent electrode line was installed in a substrate holder of a vacuum vapor deposition apparatus, and N,N'-bis(3-tolyl)-N,N'-diphenylbenzidine (mTPD) was deposited (0.5 Å/s) by resistive heating deposition on the surface of the glass substrate on which the transparent electrode line (lower electrode) was formed so that the transparent electrode was covered. A p-type layer having a thickness of 30 nm was thus formed. $C_{60}$ fullerene (electron acceptor material (n1)) was deposited (0.5 Å/s) on the mTPD film by resistive heating deposition to form an n1 layer having a thickness of 15 nm. $C_{70}$ fullerene (electron acceptor material (n2)) was deposited (0.5 Å/s) on the n1 layer by resistive heating deposition to form an n2 layer having a thickness of 45 nm. Bathocuproine (BCP) (electron acceptor material (n3)) was deposited (1 Å/s) on the n2 layer by resistive heating deposition to form an n3 layer having a thickness of 10 nm. Finally, Al was deposited as an opposite electrode to a thickness of 80 nm to obtain an organic solar battery. The area of the organic solar battery was 0.05 $cm^2$. The current density-voltage (I-V) characteristics of the organic solar battery were measured under AM1.5 conditions (light intensity: 100 $mW/cm^2$) using a pseudo-solar irradiation apparatus. The open-circuit voltage (Voc), the short circuit current density (Jsc), the fill factor (FF), and the photoelectric conversion efficiency (η) thus measured are shown in Table 1.

The structural formula and the thin-film absorption spectrum peak wavelength of each material used in the examples are given below.

mTPD

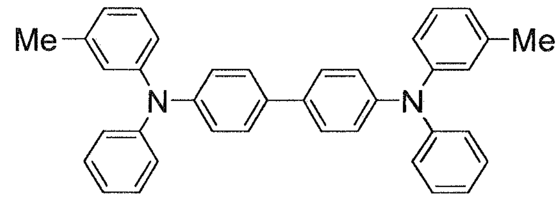

$C_{60}$ fullerene, peak wavelength: 450 nm

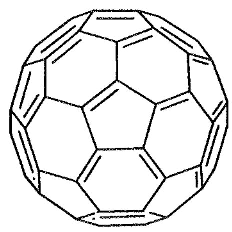

$C_{70}$ fullerene, peak wavelength: 510 nm

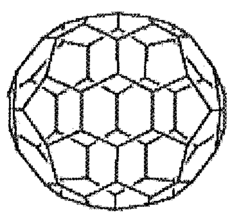

BCP, peak wavelength: 300 nm

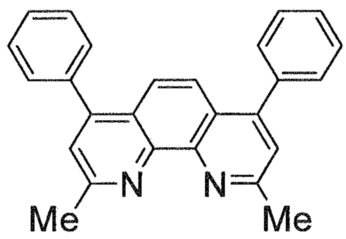

The photoelectric conversion efficiency was calculated by the following expression.

$$\eta\ (\%) = \frac{Voc \times Jsc \times FF}{P_{in}} \times 100$$

Voc: open-circuit voltage
Jsc: short circuit current density
FF: fill factor
$P_{in}$: light intensity

An organic solar battery exhibits excellent conversion efficiency when the organic solar battery has a large value for Voc, Jsc, and FF at an identical light intensity ($P_{in}$).

(Example 2)

An organic solar battery was produced in the same manner as in Example 1, except for changing the thickness of the n1 layer and the thickness of the n2 layer to 30 nm. The I-V characteristics of the organic solar battery were measured under AM1.5 conditions. The open-circuit voltage (Voc), the short circuit current density (Jsc), the fill factor (FF), and the photoelectric conversion efficiency (η) thus measured are shown in Table 1.

(Example 3)

An organic solar battery was produced in the same manner as in Example 1, except for changing the thickness of the n1 layer to 45 nm, and changing the thickness of the n2 layer to 15 nm. The I-V characteristics of the organic solar battery were measured underAM1.5 conditions. The open-circuit voltage (Voc), the short circuit current density (Jsc), the fill factor (FF), and the photoelectric conversion efficiency (η) thus measured are shown in Table 1.

(Example 4)

A glass substrate with an ITO transparent electrode (25×75×0.7 mm) was subjected to ultrasonic cleaning for 5 minutes in isopropyl alcohol, and then subjected to UV ozone cleaning for 30 minutes. The cleaned glass substrate with a transparent electrode line was installed in a substrate holder of a vacuum deposition apparatus, and mTPD was deposited (0.5 Å/s) by resistive heating deposition on the surface of the glass substrate on which the transparent electrode line (lower electrode) was formed so that the transparent electrode was covered. A p-type layer having a thickness of 30 nm was thus formed. $C_{70}$ fullerene (electron acceptor material) was deposited (0.5 Å/s) on the mTPD film by resistive heating deposition to form an n1 layer having a thickness of 15 nm. $C_{60}$ fullerene (electron acceptor material) was deposited (0.5 Å/s) on the n1 layer by resistive heating deposition to form an n2 layer having a thickness of 45 nm. Bathocuproine (BCP) (electron acceptor material) was deposited (1 Å/s) on the n2 layer by resistive heating deposition to form an n3 layer having a thickness of 10 nm. Al was then deposited as an opposite electrode to a thickness of 80 nm to obtain an organic solar battery. The area of the organic solar battery was 0.05 $cm^2$. The I-V characteristics of the organic solar battery were measured under AM1.5 conditions (light intensity: 100 $W/cm^2$). The open-circuit voltage (Voc), the short circuit current density (Jsc), the fill factor (FF), and the photoelectric conversion efficiency (η) thus measured are shown in Table 1.

(Example 5)

An organic solar battery was produced in the same manner as in Example 4, except for changing the thickness of the n1 layer and the thickness of the n2 layer to 30 nm. The I-V characteristics of the organic solar battery were measured underAM1.5 conditions. The open-circuit voltage (Voc), the short circuit current density (Jsc), the fill factor (FF), and the photoelectric conversion efficiency (η) thus measured are shown in Table 1.

(Example 6)

An organic solar battery was produced in the same manner as in Example 4, except for changing the thickness of the η1 layer to 45 nm, and changing the thickness of the n2 layer to 15 nm. The I-V characteristics of the organic solar battery were measured under AM1.5 conditions. The open-circuit voltage (Voc), the short circuit current density (Jsc), the fill factor (FF), and the photoelectric conversion efficiency (η) thus measured are shown in Table 1.

(Example 7)

A glass substrate with an ITO transparent electrode (25×75×0.7 mm) was subjected to ultrasonic cleaning for 5 minutes in isopropyl alcohol, and then subjected to UV ozone cleaning for 30 minutes. The cleaned glass substrate with a transparent electrode line was installed in a substrate holder of a vacuum deposition apparatus, and mTPD was deposited (0.5 Å/s) by resistive heating deposition on the surface of the glass substrate on which the transparent electrode line (lower electrode) was formed so that the transparent electrode was covered. A p-type layer having a thickness of 30 nm was thus formed. $C_{60}$ fullerene (electron acceptor material (n1)) and $C_{70}$ fullerene (electron acceptor material (n2)) were co-deposited (0.3 Å/s) on the mTPD film by resistive heating deposition to form a mixed n-type electron acceptor thin film (mixing ratio by weight: n1:n2=1:1) having a thickness of 60 nm.
Bathocuproine (BCP) (electron acceptor material (n3)) was deposited (1 Å/s) on the resulting thin film by resistive heating deposition to form an n3 layer having a thickness of 10 nm. Finally, Al was then deposited as an opposite electrode to a thickness of 80 nm to obtain an organic solar battery. The area of the organic solar battery was 0.05 $cm^2$. The I-V characteristics of the organic solar battery were measured underAM1.5 conditions (light intensity: 100 $mW/cm^2$). The open-circuit voltage (Voc), the short circuit current density (Jsc), the fill factor (FF), and the photoelectric conversion efficiency (η) thus measured are shown in Table 2.

(Example 8)

An organic solar battery was produced in the same manner as in Example 7, except for changing the mixing ratio of the material n1 to the material n2 to 1:2 (deposition rate: 0.1 Å/s and 0.2 Å/s, respectively). The I-V characteristics of the organic solar battery were measured under AM1.5 conditions (light intensity: 100 $mW/cm^2$). The open-circuit voltage (Voc), the short circuit current density (Jsc), the fill factor (FF), and the photoelectric conversion efficiency (η) thus measured are shown in Table 2.

(Example 9)

An organic solar battery was produced in the same manner as in Example 7, except for changing the mixing ratio of the material n1 to the material n2 to 2:1 (deposition rate: 0.2 Å/s and 0.1 Å/s, respectively). The I-V characteristics of the organic solar battery were measured under AM1.5 conditions (light intensity: 100 $mW/cm^2$). The open-circuit voltage (Voc), the short circuit current density (Jsc), the fill factor (FF), and the photoelectric conversion efficiency (η) thus measured are shown in Table 2.

(Example 10)

A glass substrate with an ITO transparent electrode (25×75×0.7 mm) was subjected to ultrasonic cleaning for 5 minutes in isopropyl alcohol, and then subjected to UV ozone cleaning for 30 minutes. The cleaned glass substrate with a transparent electrode line was installed in a substrate holder of a vacuum deposition apparatus, and mTPD was deposited (0.5 Å/s) by resistive heating deposition on the surface of the glass substrate on which the transparent electrode line (lower electrode) was formed so that the transparent electrode was covered. A p-type layer having a thickness of 30 nm was thus formed. $C_{60}$ fullerene (electron acceptor material (n1)) was deposited (1 Å/s) on the mTPD film to form an n1 layer having a thickness of 30 nm. $C_{70}$ fullerene (electron acceptor material (n2)) and bathocuproine (BCP) (electron acceptor material (n3)) were co-deposited (0.3 Å/s) on the n1 layer by resistive heating deposition to form a mixed n-type electron acceptor thin film (mixing ratio by weight: n2:n3=1:1) having a thickness of 30 nm.

Al was then deposited as an opposite electrode to a thickness of 80 nm to obtain an organic solar battery. The area of the organic solar battery was 0.05 $cm^2$. The I-V characteristics of the organic solar battery were measured underAM1.5 conditions (light intensity: 100 mW/$cm^2$). The open-circuit voltage (Voc), the short circuit current density (Jsc), the fill factor (FF), and the photoelectric conversion efficiency (η) thus measured are shown in Table 2.

(Example 11)

A glass substrate with an ITO transparent electrode (25×75×0.7 mm) was subjected to ultrasonic cleaning for 5 minutes in isopropyl alcohol, and then subjected to UV ozone cleaning for 30 minutes. The cleaned glass substrate with a transparent electrode line was installed in a substrate holder of a vacuum deposition apparatus, and mTPD was deposited (0.5 Å/s) by resistive heating deposition on the surface of the glass substrate on which the transparent electrode line (lower electrode) was formed so that the transparent electrode was covered. A p-type layer having a thickness of 30 nm was thus formed. $C_{70}$ fullerene (electron acceptor material (n1)) was deposited (1 Å/s) on the mTPD film to form an n1 layer having a thickness of 30 nm. $C_{60}$ fullerene (electron acceptor material (n2)) and bathocuproine (BCP) (electron acceptor material (n3)) were co-deposited (0.3 Å/s) on the n1 layer by resistive heating deposition to form a mixed n-type electron acceptor thin film (mixing ratio by weight: n2:n3=1:1) having a thickness of 30 nm.
Finally, Al was then deposited as an opposite electrode to a thickness of 80 nm to obtain an organic solar battery. The area of the organic solar battery was 0.05 $cm^2$. The I-V characteristics of the organic solar battery were measured under AM 1.5 conditions (light intensity: 100 mW/$cm^2$). The open-circuit voltage (Voc), the short circuit current density (Jsc), the fill factor (FF), and the photoelectric conversion efficiency (η) thus measured are shown in Table 2.

(Example 12)

A glass substrate with an ITO transparent electrode (25×75×0.7 mm) was subjected to ultrasonic cleaning for 5 minutes in isopropyl alcohol, and then subjected to UV ozone cleaning for 30 minutes. The cleaned glass substrate with a transparent electrode line was installed in a substrate holder of a vacuum deposition apparatus, and mTPD was deposited (0.5 Å/s) by resistive heating deposition on the surface of the glass substrate on which the transparent electrode line (lower electrode) was formed so that the transparent electrode was covered. A p-type layer having a thickness of 30 nm was thus formed. $C_{60}$ fullerene (electron acceptor material (n1)) (0.5 Å/s), $C_{70}$ fullerene (electron acceptor material (n2)) (0.5 Å/s), and bathocuproine (BCP) (electron acceptor material (n3)) (0.2 Å/s) were co-deposited on the mTPD film by resistive heating deposition to form a mixed n-type electron acceptor thin film (mixing ratio by weight: n1:n2:n3=5:5:2) having a thickness of 30 nm.
Al was then deposited as an opposite electrode to a thickness of 80 nm to obtain an organic solar battery. The area of the organic solar battery was 0.05 $cm^2$. The I-V characteristics of the organic solar battery were measured underAM1.5 conditions (light intensity: 100 mW/$om^2$). The open-circuit voltage (Voc), the short circuit current density (Jsc), the fill factor (FF), and the photoelectric conversion efficiency (η) thus measured are shown in Table 2.

(Example 13)

A glass substrate with an ITO transparent electrode (25×75×0.7 mm) was subjected to ultrasonic cleaning for 5 minutes in isopropyl alcohol, and then subjected to UV ozone cleaning for 30 minutes. The cleaned glass substrate with a transparent electrode line was installed in a substrate holder of a vacuum deposition apparatus, and an electron donor compound A was deposited (0.5 Å/s) by resistive heating deposition on the surface of the glass substrate on which the transparent electrode line (lower electrode) was formed so that the transparent electrode was covered. A p-type layer having a thickness of 30 nm was thus formed. $C_{60}$ fullerene (electron acceptor material (n1)) was deposited (0.5 Å/s) on the film of the compound A by resistive heating deposition to form an n1 layer having a thickness of 15 nm. $C_{70}$ fullerene (electron acceptor material (n2)) was deposited (0.5 Å/s) on the n1 layer by resistive heating deposition to form an n2 layer having a thickness of 45 nm. Bathocuproine (BCP) (electron acceptor material (n3)) was deposited (1 Å/s) on the resulting thin film by resistive heating deposition to form an n3 layer having a thickness of 10 nm. Finally, Al was then deposited as an opposite electrode to a thickness of 80 nm to obtain an organic solar battery. The area of the organic solar battery was 0.05 $cm^2$. The current density-voltage (I-V) characteristics of the organic solar battery were measured underAM1.5 conditions (light intensity: 100 mW/$cm^2$) using a pseudo-solar irradiation apparatus. The open-circuit voltage (Voc), the short circuit current density (Jsc), the fill factor (FF), and the photoelectric conversion efficiency (η) thus measured are shown in Table 3.
The structural formula and the thin-film absorption spectrum peak wavelength of each material used in the examples are given below.

Compound A

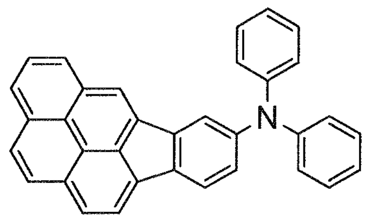

(Example 14)

An organic solar battery was produced in the same manner as in Example 13, except for changing the thickness of the n1 layer and the thickness of the n2 layer to 30 nm. The I-V characteristics of the organic solar battery were measured under AM1.5 conditions. The open-circuit voltage (Voc), the short circuit current density (Jsc), the fill factor (FF), and the photoelectric conversion efficiency (η) thus measured are shown in Table 3.

(Example 15)

An organic solar battery was produced in the same manner as in Example 13, except for changing the thickness of the n1 layer to 45 nm, and changing the thickness of the n2 layer to 15 nm. The I-V characteristics of the organic solar battery were measured under AM1.5 conditions. The open-circuit voltage (Voc), the short circuit current density (Jsc), the fill factor (FF), and the photoelectric conversion efficiency (η) thus measured are shown in Table 3.

(Example 16)

A glass substrate with an ITO transparent electrode (25×75×0.7 mm) was subjected to ultrasonic cleaning for 5 minutes in isopropyl alcohol, and then subjected to UV ozone cleaning for 30 minutes. The cleaned glass substrate with a transparent electrode line was installed in a substrate holder of a vacuum deposition apparatus, and an electron donor compound A was deposited (0.5 Å/s) by resistive heating deposition on the surface of the glass substrate on which the transparent electrode line (lower electrode) was formed so that the transparent electrode was covered. A p-type layer having a thickness of 30 nm was thus formed. $C_{70}$ fullerene (electron acceptor material) was deposited (0.5 Å/s) on the film of the compound A by resistive heating deposition to form an n1 layer having a thickness of 10 nm. $C_{60}$ fullerene (electron acceptor material) was deposited (0.5 Å/s) on the n1 layer by resistive heating deposition to form an n2 layer having a thickness of 50 nm. Bathocuproine (BCP) (electron acceptor material) was deposited (1 Å/s) on the n2 layer by resistive heating deposition to form an n3 layer having a thickness of 10 nm. Finally, Al was then deposited as an opposite electrode to a thickness of 80 nm to obtain an organic solar battery. The area of the organic solar battery was 0.05 $cm^2$. The I-V characteristics of the organic solar battery were measured under AM1.5 conditions (light intensity: 100 $mW/cm^2$). The open-circuit voltage (Voc), the short circuit current density (Jsc), the fill factor (FF), and the photoelectric conversion efficiency (η) thus measured are shown in Table 3.

(Example 17)

An organic solar battery was produced in the same manner as in Example 16, except for changing the thickness of the n1 layer to 15 nm, and changing the thickness of the n2 layer to 45 nm. The I-V characteristics of the organic solar battery were measured underAM1.5 conditions. The open-circuit voltage (Voc), the short circuit current density (Jsc), the fill factor (FF), and the photoelectric conversion efficiency (η) thus measured are shown in Table 3.

(Example 18)

An organic solar battery was produced in the same manner as in Example 16, except for changing the thickness of the n1 layer and the thickness of the n2 layer to 30 nm. The I-V characteristics of the organic solar battery were measured under AM1.5 conditions. The open-circuit voltage (Voc), the short circuit current density (Jsc), the fill factor (FF), and the photoelectric conversion efficiency (η) thus measured are shown in Table 3.

(Example 19)

An organic solar battery was produced in the same manner as in Example 16, except for changing the thickness of the n1 layer to 45 nm, and changing the thickness of the n2 layer to 15 nm. The I-V characteristics of the organic solar battery were measured underAM1.5 conditions. The open-circuit voltage (Voc), the short circuit current density (Jsc), the fill factor (FF), and the photoelectric conversion efficiency (η) thus measured are shown in Table 3.

(Example 20)

An organic solar battery was produced in the same manner as in Example 16, except for changing the thickness of the n1 layer to 50 nm, and changing the thickness of the n2 layer to 10 nm. The I-V characteristics of the organic solar battery were measured under AM1.5 conditions. The open-circuit voltage (Voc), the short circuit current density (Jsc), the fill factor (FF), and the photoelectric conversion efficiency (q) thus measured are shown in Table 3.

(Example 21)

An organic solar battery was produced in the same manner as in Example 16, except for changing the thickness of the film of the compound A to 40 nm, changing the thickness of the n1 layer to 30 nm, and changing the thickness of the n2 layer to 10 nm. The I-V characteristics of the organic solar battery were measured under AM1.5 conditions. The open-circuit voltage (Voc), the short circuit current density (Jsc), the fill factor (FF), and the photoelectric conversion efficiency (η) thus measured are shown in Table 3.

(Example 22)

A glass substrate with an ITO transparent electrode (25×75×0.7 mm) was subjected to ultrasonic cleaning for 5 minutes in isopropyl alcohol, and then subjected to UV ozone cleaning for 30 minutes. The cleaned glass substrate with a transparent electrode line was installed in a substrate holder of a vacuum deposition apparatus, and an electron donor compound A was deposited (0.5 Å/s) by resistive heating deposition on the surface of the glass substrate on which the transparent electrode line (lower electrode) was formed so that the transparent electrode was covered. A p-type layer having a thickness of 30 nm was thus formed. $C_{60}$ fullerene (electron acceptor material (n1)) and $C_{70}$ fullerene (electron acceptor material (n2)) were co-deposited (0.3 Å/s) on the film of the compound A by resistive heating deposition to form a mixed n-type electron acceptor thin film (mixing ratio by weight: n1:n2=1:1) having a thickness of 60 nm.
Bathocuproine (BCP) (electron acceptor material (n3)) was deposited (1 Å/s) on the resulting thin film by resistive heating deposition to form an n3 layer having a thickness of 10 nm. Al was then deposited as an opposite electrode to a thickness of 80 nm to obtain an organic solar battery. The area of the organic solar battery was 0.05 $cm^2$. The I-V characteristics of the organic solar battery were measured under AM1.5 conditions (light intensity: 100 $mW/cm^2$). The open-circuit voltage (Voc), the short circuit current density (Jsc), the fill factor (FF), and the photoelectric conversion efficiency (η) thus measured are shown in Table 4.

(Example 23)

A glass substrate with an ITO transparent electrode (25×75×0.7 mm) was subjected to ultrasonic cleaning for 5 minutes in isopropyl alcohol, and then subjected to UV ozone cleaning for 30 minutes. The cleaned glass substrate with a transparent electrode line was installed in a substrate holder of a vacuum deposition apparatus, and an electron donor compound A was deposited (0.5 Å/s) by resistive heating deposition on the surface of the glass substrate on which the transparent electrode line (lower electrode) was formed so that the transparent electrode was covered. A p-type layer having a thickness of 30 nm was thus formed. $C_{60}$ fullerene (electron acceptor material (n1)) was deposited (1 Å/s) on the film of the compound A to form an n1 layer having a thickness of 30 nm. $C_{70}$ fullerene (electron acceptor material (n2)) and bathocuproine (BCP) (electron acceptor material (n3)) were co-deposited (0.3 Å/s) on the n1 layer by resistive heating deposition to form a mixed n-type electron acceptor thin film (mixing ratio by weight: n2:n3=1:1) having a thickness of 30 nm.
Finally, Al was then deposited as an opposite electrode to a thickness of 80 nm to obtain an organic solar battery. The area of the organic solar battery was 0.05 $cm^2$. The I-V characteristics of the organic solar battery were measured under AM1.5 conditions (light intensity: 100 $mW/cm^2$). The open-circuit voltage (Voc), the short circuit current density (Jsc), the fill factor (FF), and the photoelectric conversion efficiency (η) thus measured are shown in Table 4.

(Example 24)

A glass substrate with an ITO transparent electrode (25×75×0.7 mm) was subjected to ultrasonic cleaning for 5 minutes in isopropyl alcohol, and then subjected to UV ozone cleaning for 30 minutes. The cleaned glass substrate with a transparent electrode line was installed in a substrate holder of a vacuum deposition apparatus, and an electron donor compound A was deposited (0.5 Å/s) by resistive heating deposition on the surface of the glass substrate on which the transparent electrode line (lower electrode) was formed so that the transparent electrode was covered. A p-type layer having a thickness of 30 nm was thus formed. $C_{70}$ fullerene (electron acceptor material (n1)) was deposited (1 Å/s) on the film of the compound A to form an n1 layer having a thickness of 30 nm. $C_{60}$ fullerene (electron acceptor material (n2)) and bathocuproine (BCP) (electron acceptor material (n3)) were co-deposited (0.3 Å/s) on the n1 layer by resistive heating deposition to form a mixed n-type electron acceptor thin film (mixing ratio by weight: n2:n3=1:1) having a thickness of 30 nm.
Finally, Al was then deposited as an opposite electrode to a thickness of 80 nm to obtain an organic solar battery. The area of the organic solar battery was 0.05 $cm^2$ . The I-V characteristics of the organic solar battery were measured underAM1.5 conditions (light intensity: 100 $mW/cm^2$). The open-circuit voltage (Voc), the short circuit current density (Jsc), the fill factor (FF), and the photoelectric conversion efficiency (η) thus measured are shown in Table 4.

(Example 25)

A glass substrate with an ITO transparent electrode (25×75×0.7 mm) was subjected to ultrasonic cleaning for 5 minutes in isopropyl alcohol, and then subjected to UV ozone cleaning for 30 minutes. The cleaned glass substrate with a transparent electrode line was installed in a substrate holder of a vacuum deposition apparatus, and an electron donor compound A was deposited (0.5 Å/s) by resistive heating deposition on the surface of the glass substrate on which the transparent electrode line (lower electrode) was formed so that the transparent electrode was covered. A p-type layer having a thickness of 30 nm was thus formed. $C_{60}$ fullerene (electron acceptor material (n1)) (0.5 Å/s), $C_{70}$ fullerene (electron acceptor material (n2)) (0.5 Å/s), and bathocuproine (BCP) (electron acceptor material (n3)) (0.2 Å/s) were co-deposited on the film of the compound A by resistive heating deposition to form a mixed n-type electron acceptor thin film (mixing ratio by weight: n1 :n2:n3=5:5:2) having a thickness of 30 nm.
Finally, Al was then deposited as an opposite electrode to a thickness of 80 nm to obtain an organic solar battery. The area of the organic solar battery was 0.05 $cm^2$. The I-V characteristics of the organic solar battery were measured under AM1.5 conditions (light intensity: 100 $mW/cm^2$) . The open-circuit voltage (Voc), the short circuit current density (Jsc), the fill factor (FF), and the photoelectric conversion efficiency (η) thus measured are shown in Table 4.

(Comparative Example 1)

A glass substrate with an ITO transparent electrode (25×75×0.7 mm) was subjected to ultrasonic cleaning for 5 minutes in isopropyl alcohol, and then subjected to UV ozone cleaning for 30 minutes. The cleaned glass substrate with a transparent electrode line was installed in a substrate holder of a vacuum deposition apparatus, and mTPD was deposited (0.5 Å/s) by resistive heating deposition on the surface of the glass substrate on which the transparent electrode line (lower electrode) was formed so that the transparent electrode was covered. A p-type layer having a thickness of 30 nm was thus formed. $C_{60}$ fullerene (electron acceptor material) was deposited (0.5 Å/s) on the mTPD film by resistive heating deposition to form an n-type layer having a thickness of 60 nm.
Finally, Ag was then deposited as an opposite electrode to a thickness of 100 nm to obtain an organic solar battery. The area of the organic solar battery was 0.05 $cm^2$. The I-V characteristics of the organic solar battery were measured under AM 1.5 conditions (light intensity: 100 $mW/cm_2$). The open-circuit voltage (Voc), the short circuit current density (Jsc), the fill factor (FF), and the photoelectric conversion efficiency (η) thus measured are shown in Table 1.

(Comparative Example 2)

A glass substrate with an ITO transparent electrode (25×75×0.7 mm) was subjected to ultrasonic cleaning for 5 minutes in isopropyl alcohol, and then subjected to UV ozone cleaning for 30 minutes. The cleaned glass substrate with a transparent electrode line was installed in a substrate holder of a vacuum deposition apparatus, and mTPD was deposited (0.5 Å/s) by resistive heating deposition on the surface of the glass substrate on which the transparent electrode line (lower electrode) was formed so that the transparent electrode was covered. A p-type layer having a thickness of 30 nm was thus formed. PTCBI (electron acceptor material (n1)) was deposited (0.5 Å/s) on the mTPD film by resistive heating deposition to form an n1 layer having a thickness of 60 nm. Bathocuproine (BCP) (electron acceptor material) was deposited (1 Å/s) on the n1 layer by resistive heating deposition to form an n2 layer having a thickness of 10 nm.
Finally, Ag was then deposited as an opposite electrode to a thickness of 100 nm to obtain an organic solar battery. The

area of the organic solar battery was 0.05 $cm^2$. The I-V characteristics of the organic solar battery were measured under AM1.5 conditions (light intensity: 100 $mW/cm^2$). The open-circuit voltage (Voc), the short circuit current density (Jsc), the fill factor (FF), and the photoelectric conversion efficiency (η) thus measured are shown in Table 1.

PTCBI

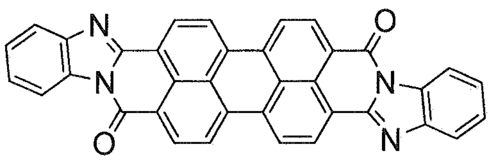

(Comparative Example 3)

A glass substrate with an ITO transparent electrode (25×75×0.7 mm) was subjected to ultrasonic cleaning for 5 minutes in isopropyl alcohol, and then subjected to UV ozone cleaning for 30 minutes. The cleaned glass substrate with a transparent electrode line was installed in a substrate holder of a vacuum deposition apparatus, and mTPD was deposited (0.5 Å/s) by resistive heating deposition on the surface of the glass substrate on which the transparent electrode line (lower electrode) was formed so that the transparent electrode was covered. A p-type layer having a thickness of 30 nm was thus formed. $C_{60}$ fullerene (electron acceptor material (n1)) was deposited (0.5 Å/s) on the mTPD film by resistive heating deposition to form an n1 layer having a thickness of 60 nm. Bathocuproine (BCP) (electron acceptor material) was deposited (1 Å/s) on the n1 layer by resistive heating deposition to form an n2 layer having a thickness of 10 nm. Finally, Al was then deposited as an opposite electrode to a thickness of 80 nm to obtain an organic solar battery. The area of the organic solar battery was 0.05 $cm^2$. The I-V characteristics of the organic solar battery were measured under AM1.5 conditions (light intensity: 100 $mW/cm^2$). The open-circuit voltage (Voc), the short circuit current density (Jsc), the fill factor (FF), and the photoelectric conversion efficiency (η) thus measured are shown in Table 1.

(Comparative Example 4)

A glass substrate with an ITO transparent electrode (25×75×0.7 mm) was subjected to ultrasonic cleaning for 5 minutes in isopropyl alcohol, and then subjected to UV ozone cleaning for 30 minutes. The cleaned glass substrate with a transparent electrode line was installed in a substrate holder of a vacuum deposition apparatus, and an electron donor compound A was deposited (0.5 A/s) by resistive heating deposition on the surface of the glass substrate on which the transparent electrode line (lower electrode) was formed so that the transparent electrode was covered. A p-type layer having a thickness of 30 nm was thus formed. $C_{60}$ fullerene (electron acceptor material (n1)) was deposited (0.5 Å/s) on the film of the compound A by resistive heating deposition to form an n1 layer having a thickness of 60 nm. Bathocuproine (BCP) (electron acceptor material) was deposited (1 Å/s) on the n1 layer by resistive heating deposition to form an n2 layer having a thickness of 10 nm. Finally, Al was then deposited as an opposite electrode to a thickness of 80 nm to obtain an organic solar battery. The area of the organic solar battery was 0.05 $cm^2$. The I-V characteristics of the organic solar battery were measured under AM1.5 conditions (light intensity: 100 $mW/cm^2$). The open-circuit voltage (Voc), the short circuit current density (Jsc), the fill factor (FF), and the photoelectric conversion efficiency (η) thus measured are shown in Table 3.

TABLE 1

| | Example | | | | | | Comparative Example | | |
|---|---|---|---|---|---|---|---|---|---|
| | 1 | 2 | 3 | 4 | 5 | 6 | 1 | 2 | 3 |
| p layer compound<br>Thickness (nm) | mTPD<br>30 | mTPD<br>30 | mTPD<br>30 | mTPD<br>30 | mTPD<br>30 | mTPD<br>30 | mTPD<br>30 | mTPD<br>30 | mTPD<br>30 |
| n1 layer compound<br>Thickness (nm) | $C_{60}$<br>15 | $C_{60}$<br>30 | $C_{60}$<br>45 | $C_{70}$<br>15 | $C_{70}$<br>30 | $C_{70}$<br>45 | $C_{60}$<br>60 | PTCBI<br>60 | $C_{60}$<br>60 |
| n2 layer compound<br>Thickness (nm) | $C_{70}$<br>45 | $C_{70}$<br>30 | $C_{70}$<br>15 | $C_{60}$<br>45 | $C_{60}$<br>30 | $C_{60}$<br>15 | -<br>0 | BCP<br>10 | BCP<br>10 |
| n3 layer compound<br>Thickness (nm) | BCP<br>10 | BCP<br>10 | BCP<br>10 | BCP<br>10 | BCP<br>10 | BCP<br>10 | -<br>0 | -<br>0 | -<br>0 |
| Voc (V) | 0.89 | 0.88 | 0.85 | 0.85 | 0.80 | 0.84 | 0.38 | 0.77 | 0.71 |
| Jsc ($mA/cm^2$) | 4.03 | 3.86 | 2.93 | 4.22 | 3.48 | 5.26 | 1.16 | 0.51 | 0.71 |
| FF | 0.37 | 0.39 | 0.36 | 0.24 | 0.38 | 0.27 | 0.25 | 0.35 | 0.34 |
| $\eta$ (%) | 1.31 | 1.31 | 0.89 | 0.87 | 1.06 | 1.17 | 0.11 | 0.14 | 0.17 |

TABLE 2

| | Example 7 | Example 8 | Example 9 |
|---|---|---|---|
| p layer compound<br>Thickness (nm) | mTPD<br>30 | mTPD<br>30 | mTPD<br>30 |
| n layer compound mixture<br>Mixing ratio<br>Thickness (nm) | $C_{60}$:$C_{70}$<br>1:1<br>60 | $C_{60}$:$C_{70}$<br>1:2<br>60 | $C_{60}$:$C_{70}$<br>2:1<br>60 |
| n3 layer compound<br>Thickness (nm) | BCP<br>10 | BCP<br>10 | BCP<br>10 |
| Voc (V) | 0.85 | 0.80 | 0.81 |
| Jsc (mA/cm$^2$) | 4.14 | 3.22 | 3.37 |
| FF | 0,34 | 0.38 | 0.36 |
| η (%) | 1.19 | 0.96 | 0.98 |

| | Example 10 | Example 11 |
|---|---|---|
| p layer compound<br>Thickness (nm) | mTPD<br>30 | mTPD<br>30 |
| n1 layer compound<br>Thickness (nm) | $C_{60}$<br>30 | $C_{70}$<br>30 |
| n layer compound mixture<br>Mixing ratio<br>Thickness (nm) | $C_{70}$,BCP<br>1:1<br>30 | $C_{60}$<br>:BCP 1:1 |
| Voc (V) | 0.87 | 0.82 |
| Jsc (mA/cm$^2$) | 2.77 | 3.89 |
| FF | 0.35 | 0.33 |
| η (%) | 0.84 | 1.03 |

| | Example 12 |
|---|---|
| p layer compound<br>Thickness (nm) | mTPD<br>30 |
| n layer compound mixture<br>Mixing ratio<br>Thickness (nm) | $C_{60}$:$C_{70}$:BCP<br>5:5:2<br>30 |
| Voc (V) | 0.81 |
| Jsc (mA/cm$^2$) | 0.93 |
| FF | 0.38 |
| η (%) | 0.28 |

TABLE 3

| | Example | | | | | | | | | Comparative Example |
|---|---|---|---|---|---|---|---|---|---|---|
| | 13 | 14 | 15 | 16 | 17 | 18 | 19 | 20 | 21 | 4 |
| player compound Thickness (nm) | Compound A 30 | Compound A 30 | Compound A 30 | Compound A 30 | Compound A 30 | Compound A 30 | Compound A 30 | Compound A 30 | Compound A 40 | Compound A 30 |
| n1 layer compound Thickness (nm) | $C_{60}$ 15 | $C_{60}$ 30 | $C_{60}$ 45 | $C_{70}$ 10 | $C_{70}$ 15 | $C_{70}$ 30 | $C_{70}$ 45 | $C_{70}$ 50 | $C_{70}$ 30 | $C_{70}$ 60 |
| n2 layer compound Thickness (nm) | $C_{70}$ 45 | $C_{70}$ 30 | $C_{70}$ 15 | $C_{60}$ 50 | $C_{60}$ 45 | $C_{60}$ 30 | $C_{60}$ 15 | $C_{60}$ 10 | $C_{60}$ 10 | BCP 10 |
| n3 layer compound Thickness (nm) | BCP 10 | BCP 10 | BCP 10 | BCP 10 | BCP 10 | BCP 10 | BCP 10 | BCP 10 | BCP 10 | - 0 |
| Voc (V) | 0.93 | 0.93 | 0.94 | 0.89 | 0.88 | 0.88 | 0.88 | 0.89 | 0.93 | 0.92 |
| Jsc ($mA/cm^2$) | 3.08 | 4.07 | 4.67 | 4.45 | 3.77 | 5.86 | 4.66 | 4.12 | 6.50 | 2.90 |
| FF | 0.62 | 0.62 | 0.64 | 0.62 | 0.61 | 0.60 | 0.62 | 0.63 | 0.61 | 0.47 |
| $\eta$(%) | 1.76 | 2.34 | 2.80 | 2.44 | 2.01 | 3.10 | 2.57 | 2.29 | 3.70 | 1.26 |

TABLE 4

| | Example | | Example | | | Example |
|---|---|---|---|---|---|---|
| | 22 | | 23 | 24 | | 25 |
| p layer compound<br>Thickness (nm) | Compound A<br>30 | p layer compound<br>Thickness (nm) | Compound A<br>30 | Compound A<br>30 | p layer compound<br>Thickness (nm) | Compound A<br>30 |
| n layer compound mixture<br>Mixing ratio<br>Thickness (nm) | $C_{60}$:$C_{70}$<br>1:1<br>60 | n1 layer compound<br>Thickness (nm) | $C_{60}$<br>30 | $C_{70}$<br>30 | n layer compound mixture<br>Mixing ratio<br>Thickness (nm) | $C_{60}$:$C_{70}$:BCP<br>5:5:2<br>30 |
| n3 layer compound<br>Thickness (nm) | BCP<br>10 | n layer compound mixture<br>Mixing ratio<br>Thickness (nm) | $C_{70}$:BCP<br>1:1<br>30 | $C_{60}$:BCP<br>1:1<br>30 | | |
| Voc (V) | 0.90 | Voc (V) | 0.92 | 0.87 | Voc (V) | 0.90 |
| Jsc (mA/cm$^2$) | 3.52 | Jsc (mA/cm$^2$) | 2.36 | 3.31 | Jsc (mA/cm$^2$) | 2.29 |
| FF | 0.65 | FF | 0.67 | 0.63 | FF | 0.63 |
| 11(%) | 2.04 | 11(%) | 1.44 | 1.77 | η (%) | 1.30 |

As is clear from the results shown in Tables 1 to 4, the photoelectric conversion efficiency was improved, and excellent solar battery characteristics were obtained by utilizing the photoelectric conversion layer produced by stacking (mixing) the electron donor layer and the electron acceptor layer including three electron acceptor materials.

INDUSTRIAL APPLICABILITY

The organic solar battery according to the invention exhibits high photoelectric conversion efficiency, and may suitably be used to produce a photoelectric conversion module, a solar panel, a solar battery array, and the like having high photoelectric conversion efficiency.

Although only some exemplary embodiments and/or examples of this invention have been described in detail above, those skilled in the art will readily appreciate that many modifications are possible in the exemplary embodiments and/or examples without materially departing from the novel teachings and advantages of this invention. Accordingly, all such modifications are intended to be included within the scope of this invention.

The documents cited in the specification are incorporated herein by reference in their entirety.

**Claims**

1. An organic solar battery comprising a photoelectric conversion layer that comprises an electron donor layer and an electron acceptor layer stacked on the electron donor layer, the electron acceptor layer including three or more electron acceptor materials, and at least one of the three or more electron acceptor materials being an organic material.

2. The organic solar battery according to claim 1, wherein the electron acceptor layer comprises a plurality of layers that respectively include one of the three or more electron acceptor materials.

3. The organic solar battery according to claim 1, wherein the electron acceptor layer comprises a plurality of layers including a layer that includes at least two of the three or more electron acceptor materials in a mixed state.

4. The organic solar battery according to claim 1, wherein the electron acceptor layer includes a single layer that includes the three or more electron acceptor materials in a mixed state.

5. The organic solar battery according to any one of claims 1 to 4, wherein the three or more electron acceptor materials differ in thin-film absorption spectrum peak wavelength.

6. The organic solar battery according to any one of claims 1 to 5, wherein at least one of the three or more electron acceptor materials is selected from the group consisting of fullerenes.

7. The organic solar battery according to any one of claims 1 to 6, wherein one of the three or more electron acceptor materials is $C_{60}$ fullerene, and another of the three or more electron acceptor materials is selected from the group consisting of fullerenes having 61 or more carbon atoms.

FIG.1

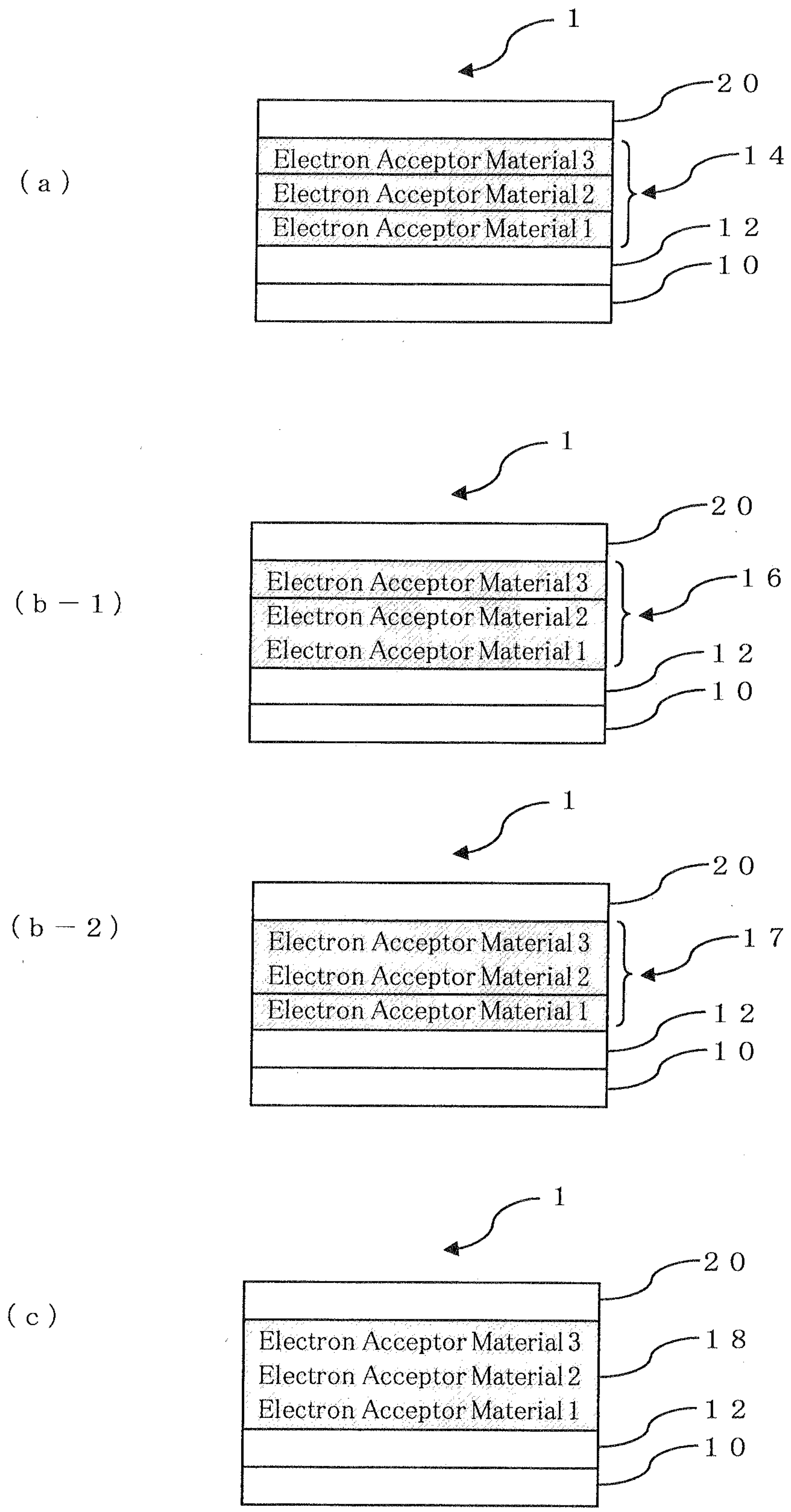
(a)
1
20
Electron Acceptor Material 3
Electron Acceptor Material 2
Electron Acceptor Material 1
14
12
10
(b-1)
1
20
Electron Acceptor Material 3
Electron Acceptor Material 2
Electron Acceptor Material 1
16
12
10
(b-2)
1
20
Electron Acceptor Material 3
Electron Acceptor Material 2
Electron Acceptor Material 1
17
12
10
(c)
1
20
Electron Acceptor Material 3
Electron Acceptor Material 2
Electron Acceptor Material 1
18
12
10

**INTERNATIONAL SEARCH REPORT**

International application No.
PCT/JP2009/005696

A. CLASSIFICATION OF SUBJECT MATTER
*H01L51/42*(2006.01)i

According to International Patent Classification (IPC) or to both national classification and IPC

B. FIELDS SEARCHED

Minimum documentation searched (classification system followed by classification symbols)
H01L51/42-51/48

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)
JSTPlus(JDreamII), JST7580(JDreamII)

C. DOCUMENTS CONSIDERED TO BE RELEVANT

| Category* | Citation of document, with indication, where appropriate, of the relevant passages | Relevant to claim No. |
|---|---|---|
| X<br>Y | JP 5-308146 A (Ricoh Co., Ltd.), 19 November 1993 (19.11.1993), paragraphs [0101] to [0102]; fig. 2 & US 5350459 A | 1,2,5,6<br>3 |
| X<br>Y | JP 5-335614 A (Idemitsu Kosan Co., Ltd.), 17 December 1993 (17.12.1993), paragraphs [0020], [0027]; fig. 1 (Family: none) | 4,7<br>3 |
| A | JP 2006-13097 A (Bridgestone Corp.), 12 January 2006 (12.01.2006), paragraphs [0027], [0038], [0042]; fig. 1 to 2 (Family: none) | 1-7 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 22 January, 2010 (22.01.10) | 02 February, 2010 (02.02.10) |

| Name and mailing address of the ISA/ | Authorized officer |
|---|---|
| Japanese Patent Office | |
| Facsimile No. | Telephone No. |

Form PCT/ISA/210 (second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **C. W. Tang.** *Appl. Phys. Lett.,* 1986, vol. 48, 183
- **P. Peumans ; V. Bulovic ; S. R. Forrest.** *Appl. Phys. Lett.,* 2000, vol. 76, 2650
- **P. Peumans ; S. R. Forrest.** *Appl. Phys. Lett.,* 2001, vol. 79, 126